Europäisches Patentamt

European Patent Office

Office européen des brevets

(11) Numéro de publication: **0 130 899**
**A2**

(12) **DEMANDE DE BREVET EUROPEEN**

(21) Numéro de dépôt: 84401332.6

(22) Date de dépôt: 26.06.84

(51) Int. Cl.⁴: **H 04 J 3/06, H 04 L 25/36, H 03 M 9/00**

(30) Priorité: 30.06.83 FR 8310910

(43) Date de publication de la demande: 09.01.85
Bulletin 85/2

(84) Etats contractants désignés: DE GB IT NL

(71) Demandeur: **THOMSON-CSF, 173, Boulevard Haussmann, F-75379 Paris Cedex 08 (FR)**

(72) Inventeur: **Grimaldi, Jean-Luc, THOMSON-CSF SCPI 173, bld Haussmann, F-75379 Paris Cedex 08 (FR)**

(74) Mandataire: **Turlèque, Clotilde et al, THOMSON-CSF SCPI 173, Bld Haussmann, F-75379 Paris Cedex 08 (FR)**

(54) **Circuit programmable de transformation série-parallèle d'un signal numérique, et son application à un récepteur de signaux vidéo numériques.**

(57) Le circuit programmable de transformation série-parallèle d'un signal numérique, et son application à un récepteur de signaux vidéo numériques.

Le circuit programmable de transformation série-parallèle comporte un circuit détecteur (6) des mots de synchronisation dans le signal numérique série, un comparateur de phase (7) générant des impulsions I et Ī caractéristiques des coïncidences et des non-coïncidences entre le signal d'horloge parallèle, généré par un diviseur programmable (8) à partir du signal d'horloge série, et des impulsions caractéristiques des instants de détection des mots de synchronisation; un circuit logique (9) reçoit les impulsions du comparateur de phase et les transmet à l'entrée de commande de synchronisation du diviseur programmable lorsqu'un nombre prédéterminé programmable de non-coïncidences ou de coïncidences successives a été détecté. Ce circuit logique a également une entrée de commande de débrayage. Le circuit est implanté dans un réseau intégré prédiffusé.

Application, notamment, à la transmission de signaux de télévision numériques.

1

Circuit programmable de transformation série-parallèle d'un signal numérique, et son application à un récepteur de signaux vidéo numériques

L'invention se rapporte au traitement de signaux numériques et a plus particulièrement pour objet un circuit programmable de transformation série-parallèle d'un signal numérique, et son application à un récepteur de signaux vidéo numériques.

Les systèmes de transmission de signaux vidéo numérisés convertissent à l'émission le signal vidéo analogique en un train parallèle de huit éléments binaires par codage de 256 niveaux. Ces signaux peuvent être exploités tels quels dans une station de réception, mais lorsque ces signaux doivent être transmis, il le sont généralement sous forme de trains numériques série. Des dispositifs de transcodage effectuent cette conversion parallèle-série.

Le dispositif de réception associé comporte un circuit de récupération de la synchronisation associé à un circuit de transcodage inverse série-parallèle, permettant à partir du train série de restituer la suite des mots binaires parallèles correspondant à la suite des niveaux du signal vidéo. Le circuit de récupération de la synchronisation permet de reconnaître le début des mots codés dans le train numérique série. Pour cela, dans le signal codé, des séquences de synchronisation formant la trame numérique sont ajoutées à l'information proprement dite et transmises pendant les périodes de synchronisation, par exemple pendant les impulsions de synchronisation ligne. Ces séquences sont constituées de mot(s) de synchronisation choisis pour ne pas être retrouvés dans le train série des mots codés. Dans le dispositif de réception, ces séquences de synchronisation sont détectées et permettent de synchroniser un signal d'horloge "parallèle" correspondant aux débuts des mots codés dans le train numérique série.

Lors de la transmission, le canal de transmission introduit une dégradation du signal qui se traduit par des erreurs dans les données reçues qui affectent de la même manière l'information et les séquences de synchronisation. Il est donc nécessaire de prévoir un circuit de transformation série-parallèle qui évite les désynchronisations dues aux erreurs de transmission.

L'invention a pour objet un tel circuit de transformation série-parallèle, modulaire, dont certains paramètres sont programmables et qui se prête donc à un grand nombre de stratégies de synchronisation. Ce circuit permet en particulier d'éviter les désynchronisations lorsque le taux d'erreurs de transmission est non négligeable, au moyen d'un circuit logique dit "générateur d'hystérésis".

Suivant l'invention, un circuit de transformation série-parallèle d'un signal numérique série en une suite de mots binaires parallèles comportant un registre à décalage d'entrée commandé par une horloge série, et relié à un registre à mémoire commandé par une horloge parallèle, ce signal série comportant des séquences de mots de synchronisation fixant sa trame, est caractérisé en ce qu'il comporte, en combinaison, un circuit détecteur de coïncidences ayant une première entrée qui reçoit un mot de synchronisation de référence, une seconde entrée recevant le signal numérique série et une sortie délivrant des impulsions de coïncidence lorsque le mot de référence est détecté dans le signal numérique série, un comparateur de phase recevant d'une part les impulsions de coïncidence et d'autre part un signal de référence de phase, au rythme des mots parallèles, issu d'un diviseur dont le rang de division est programmable en fonction du nombre d'éléments binaires de mots parallèles, commandé par l'horloge associée au train numérique série, ce comparateur délivrant des impulsions $I$ ou $\bar{I}$ sur deux sorties suivant que les impulsions de coïncidence sont en phase ou non avec le signal de référence de phase, et un circuit logique à hystérésis relié aux sorties du comparateur transmettant sur ses sorties des impulsions $I$ ou $\bar{I}$ validées lorsqu'un nombre prédéterminé d'impulsions successives de coïncidences ou de non coïncidences sont détectées, les impulsions validées étant appliquées à l'entrée de commande de synchronisation du diviseur programmable.

L'invention sera mieux comprise et d'autres caractéristiques apparaîtront à l'aide de la description qui suit en référence aux figures annexées.

- La figure 1 est un schéma synoptique du circuit programmable de transformation série-parallèle d'un signal numérique suivant l'invention.

- La figure 2 est un schéma d'ensemble d'un récepteur de signaux vidéo numérisés et sérialisés.

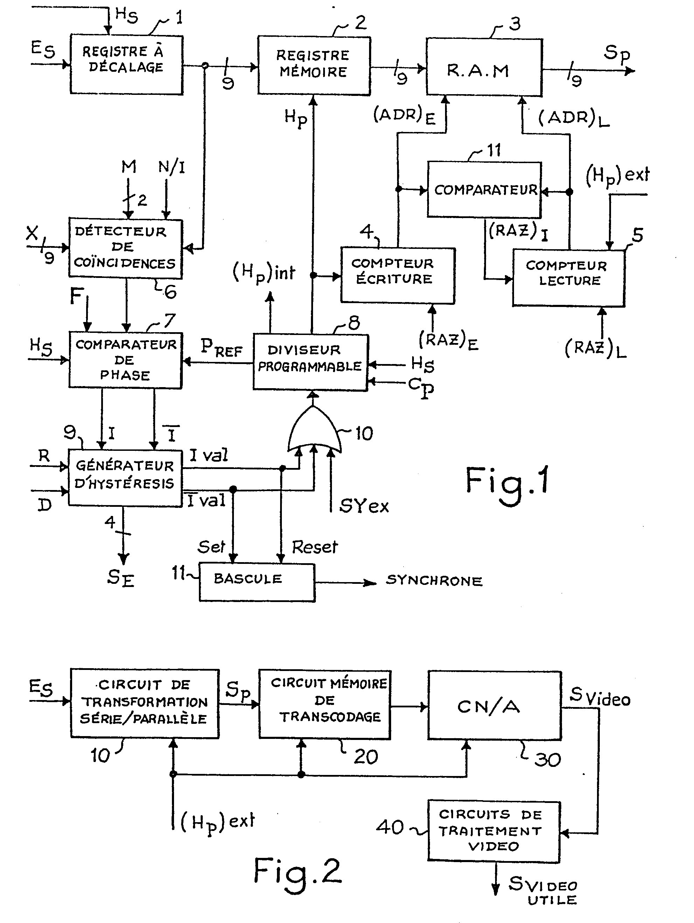

La description qui suit en référence à la figure 1 est donnée pour un exemple de signal numérique transcodé suivant le procédé de transcodage décrit dans la demande de brevet français n° 80 25907 au nom de la Demanderesse, chaque mot parallèle de huit bits ayant donné lieu à une suite de données série de neuf bits, selon un code particulier ; un mot de synchronisation trame numérique, X, comportant également neuf bits et son complément à 1, $\overline{X}$, sont transmis alternativement durant les impulsions de synchronisation et les intervalles de suppression du signal vidéo, pour former des séquences de synchronisation trame numériques.

Le circuit programmable suivant l'invention comporte une entrée série $E_S$ reliée à l'entrée d'un registre à décalage 1 à neuf étages ; ce registre a une entrée d'horloge de décalage recevant un signal d'horloge $H_S$ à la fréquence des éléments binaires du train série. La sortie multiple de ce registre à décalage, formée de 9 sorties parallèles, est reliée à l'entrée multiple correspondante d'un registre mémoire 2 qui a également une entrée d'horloge. Les sorties parallèles de ce registre mémoire sont reliées aux entrées parallèles d'une mémoire RAM 3 de quatre étages de neuf bits. Cette mémoire RAM 3 est commandée par un compteur d'adresses écriture, 4, dont la sortie d'adresse $ADR_{(E)}$ est reliée à l'entrée de commande d'écriture de la RAM 3. Un compteur d'adresses de lecture 5 commande la lecture de la RAM 3 par sa sortie d'adresse $ADR_{(L)}$. Les données parallèles sortent de la RAM 3 pour former le train de mots parallèles $S_P$.

Pour obtenir une synchronisation convenable du transfert du registre à décalage 1 dans le registre à mémoire 2, puis une lecture convenable de la RAM 3, le circuit programmable suivant l'invention comporte en outre un comparateur de mots, détecteur de coïncidences, 6, comportant une première entrée multiple reliée à la sortie multiple du registre à décalage 1 et une seconde entrée multiple à laquelle est appliqué l'un des deux mots complémentaires X ou $\overline{X}$ transmis pendant la séquence de synchronisation trame numérique. Ce détecteur de coïncidences 6 comporte en outre deux entrées supplémentaires : une entrée de masquage M qui permet de ne pas tenir compte de certains étages du détecteur de coïncidences lorsque, par exemple, les mots parallèles à transmettre ne comportent qu'un nombre de bits inférieur à neuf ; enfin une entrée N/I, qui permet à un opérateur de commander la comparaison du mot de sortie du registre à décalage appliqué à la première entrée du détecteur soit avec le mot de synchronisation X appliqué sur sa seconde entrée, soit avec son complément à 1, $\overline{X}$. Ce détecteur de coïncidences fonctionne au rythme de l'avance du registre à décalage 1, c'est-à-dire au rythme de l'horloge série $H_S$. En régime normal, l'inversion du mot de synchronisation, pris comme référence, dans le détecteur de coïncidences est commandée à chaque fois qu'une coïncidence est détectée pour tenir compte de la constitution des séquences de synchronisation X $\overline{X}$ X $\overline{X}$ ...

Une impulsion est transmise à la sortie du détecteur pour chaque coïncidence entre un mot de synchronisation et le mot de sortie du registre à décalage. La sortie de ce détecteur est reliée à l'entrée d'un comparateur de phase 7 qui compare la phase des impulsions générées par le détecteur de coïncidences avec un signal de référence de phase, $P_{REF}$, appliqué sur une seconde entrée du comparateur de phase, et issu d'un diviseur 8 du signal d'horloge série $H_S$, le comparateur comporte en outre une entrée F, dite fenêtre de validation, qui n'autorise la comparaison par le comparateur 7 que lorsqu'elle est dans un état déterminé, par exemple un état 0. Lorsque la phase de référence du diviseur et l'impulsion indiquant la coïncidence entre le mot de synchronisation affiché, ou son complément, et le mot à la sortie du registre à décalage, coïncident, le comparateur de phase 7 délivre une impulsion I sur une première sortie. Dans le cas contraire le comparateur délivre une impulsion $\overline{I}$ sur une seconde sortie. Ces impulsions I et $\overline{I}$ sont synchrones de l'horloge série $H_S$ appliquée à l'entrée d'horloge du comparateur de phase. Les sorties I et $\overline{I}$ du comparateur de phase 7 sont reliées à deux entrées d'un circuit 9 dit circuit "logique générateur d'hystérésis", comportant principalement un compteur de quatre bits, dont la fonction est de ne transmettre que des impulsions de synchronisation I ou $\overline{I}$ validées. Le fonctionnement de ce circuit sera décrit en détails ci-après. Il comporte également une entrée R dite "de réduction de dynamique", une entrée D dite "de débrayage du compteur", une sortie $S_E$ sur quatre bits indiquant l'état du compteur, et deux sorties de commande de synchronisation, l'une délivrant les impulsions I validées et l'autre délivrant les impulsions $\bar{I}$ validées. Ces sorties sont reliées à deux entrées d'une porte OU 10 qui reçoit sur une troisième entrée un signal de synchronisation externe, $SY_{ex}$. La sortie de cette porte OU est reliée à une entrée de commande de synchronisation du diviseur 8. Ce diviseur, du type diviseur en anneau, comporte un registre à décalage rebouclé sur lui-même, et a une entrée d'horloge recevant le signal d'horloge série $H_S$, une entrée de commande de programmation $C_P$ pour la détermination du rang de division de l'horloge série $H_S$, fonction du nombre de bits des mots parallèles à restituer, soit neuf dans l'exemple précité. Mais cette entrée de commande de programmation du diviseur peut permettre une division par huit ou sept suivant le nombre de bits des mots parallèles à restituer. Un certain nombre de signaux de référence sont issus de ce diviseur programmable. Ils diffèrent les uns des autres par leur phase relative, et éventuellement par leur rapport cyclique. Ce diviseur programmable fournit en particulier la phase de référence $P_{REF}$ appliquée au comparateur de phase 7, le signal d'horloge $H_P$ appliqué d'une part à l'entrée d'horloge du registre mémoire 2 d'autre part à l'entrée d'horloge du compteur d'écriture 4. Une horloge parallèle interne de même phase et de même fréquence que l'horloge parallèle $H_P$ mais ayant un rapport cyclique de 50% est également générée.

Enfin, le circuit de transformation comporte également une bascule 11 dont les entrées "Set" et "Reset" sont reliées aux sorties du circuit générateur d'hystérésis. Le signal logique de sortie "synchrone" de cette bascule indique, dans un premier état que l'horloge parallèle et le signal numérique sont synchrones et dans l'autre état que la synchronisation n'est pas acquise.

Le circuit logique générateur d'hystérésis a pour but d'éviter une désynchronisation du système lors d'erreurs de transmission générant une détection du mot de synchronisation alors que ce mot n'a pas été transmis. Le compteur à quatre bits est, dans la phase de démarrage, à un état intermédiaire 1000 (8 en décimal) et est incrémenté à la réception d'impulsions I, et décrémenté à la réception d'impulsions $\bar{I}$. En mode

compteur, lorsque le compteur a atteint un état défini comme étant l'état maximum, il ne peut plus être incrémenté. En mode décompteur, quand il atteint un état défini comme étant l'état minimum, il revient à l'état intermédiaire si une nouvelle impulsion $\overline{I}$ est reçue. Compte tenu de la capacité du compteur, il est possible de déterminer les états maximum et minimum de plusieurs façons, soit 4 et 12 pour le minimum et le maximum, ou 0 et 15. Ces couples d'états extrêmes définissent la dynamique du circuit logique, et donc l'hystérésis, et sont choisis par l'utilisateur par l'entrée R, réduction de la dynamique.

Quand le compteur atteint l'état maximum, il reste dans cet état, et toutes les impulsions I reçues par l'entrée correspondante sont alors validées et transmises à l'entrée de synchronisation du diviseur programmable, ces impulsions confirmant que la synchronisation est acquise. D'autre part, quand le compteur atteint l'état minimum, l'impulsion $\overline{I}$ suivante est transmise à l'entrée de synchronisation du diviseur programmable et commande un décalage, le compteur étant alors ramené à l'état intermédiaire 1000, comme indiqué ci-dessus.

La dynamique indiquée ci-dessus comme étant comprise soit entre 4 et 12 soit entre 0 et 15, fixe donc le nombre de non-coïncidences nécessaire pour commander une resynchronisation. En effet, en cas d'erreur de transmission, le mot de synchronisation peut être détecté dans le signal binaire série sans qu'il ait été réellement transmis. Le détecteur de coïncidences fournit alors une impulsion qui donne lieu à une impulsion I ou $\overline{I}$ de validation ou de non validation de la synchronisation qui ne correspond à rien ; le circuit générateur d'hystérésis permet de ne prendre en compte ces impulsions qu'après plusieurs coïncidences ou non coïncidences successives.

Cependant, pour des applications particulières, il peut être intéréssant de transmettre au diviseur programmable toutes les impulsions issues du comparateur de phase. Pour cela, l'entrée D de débrayage du circuit logique générateur d'hystérésis permet de rendre ce circuit transparent, toutes les impulsions reçues sur son entrée étant transmises à sa sortie. L'état du compteur reste alors à la valeur intermédiaire.

L'état du compteur est accessible, une sortie directe du compteur $S_E$ donnant l'état du compteur, sur quatre bits.

Le diviseur 8 délivre donc le signal d'horloge parallèle $H_p$, appliqué à l'entrée d'horloge du registre mémoire 2, et le signal de référence de phase $P_{REF}$ qui en est déduit, décalé en phase ou entretenu, ses transitions étant fixées par le signal de sortie de la porte OU 10, c'est-à-dire par les impulsion $I$ ou $\bar{I}$, ou par un signal de synchronisation extérieur $SY_{ext}$.

Enfin, pour que ce circuit modulaire puisse être intégré sans difficulté à un ensemble piloté par un signal d'horloge différent, c'est-à-dire par une horloge extérieure $(H_p)_{ext}$ de même rythme que $H_p$ mais éventuellement déphasée, la mémoire RAM 3 joue le rôle de mémoire tampon. Cette mémoire permet également d'absorber une gigue de phase entre $H_p$ et $(H_p)_{ext}$.

Pour cela le compteur d'adresses d'écriture 4 est incrémenté au rythme d'horloge $H_p$, et le compteur d'adresses de lecture est incrémenté au rythme du signal d'horloge extérieur $(H_p)_{ext}$. Les mots de 9 bits sont écrits consécutivement dans les quatre registres de la mémoire 4 par décodage de leurs adresses données par l'état du compteur d'écriture 4. Les sorties homologues des quatre registres sont multiplexées, et sélectionnées par l'adresse du compteur de lecture 5. Les états de ces deux compteurs 4 et 5 sont comparés dans un comparateur 11. Ainsi, si à un instant donné les deux compteurs sont dans le même état le compteur de lecture est mis à zéro pour éviter toute possibilité de conflit, écriture-lecture. Ces deux compteurs possèdent également des entrées de remise à zéro pour une action de l'extérieur par un opérateur.

Dans le cas où la transformation série-parallèle doit être effectuée sur des mots de moins de 9 bits, il suffit de ne pas considérer certains des étages des registres formant la RAM 4.

Le circuit décrit ci-dessus est particulièrement adapté, du fait du nombre des fonctions nécessaires, à une réalisation sous forme intégrée dans un circuit intégré en réseau prédiffusé comportant 60 sites par exemple.

Il permet de réaliser une transformation série-parallèle de mots de 9 bits ou moins, par exemple 8 ou 7 et peut fonctionner à une vitesse maximale de 250 M bits/s, ce qui est bien adapté à une transformation série-parallèle d'un signal vidéo numérisé au débit série de 243 M b/s (27 M bits/s x 9) en un signal organisé à terme, c'est-à-dire après le transcodage 9 bits/8 bits, en mots de 8 bits parallèles au débit de 27M octets/s.

La figure 2 montre un schéma d'ensemble d'un circuit récepteur utilisant un tel circuit de transformation série-parallèle. L'entrée série $E_S$, reçoit le signal numérisé série, par exemple au débit de 243 M b/s, issu du canal de transmission. Le circuit de transformation série-parallèle 10 décrit ci-dessus en référence à la figure 1 délivre un signal contenant les mêmes données transformées en un train de mots de 9 bits parallèles $S_p$. Ce train numérique $S_p$ est appliqué à un circuit à mémoire 20 de transcodage qui ramène les mots de 9 bits transmis aux mots de 8 bits directement liés aux niveaux du signal vidéo. La sortie du circuit de transcodage 20 est reliée à l'entrée d'un convertisseur numérique-analogique 30 qui restitue le signal vidéo sous sa forme analogique. Des circuits de traitement vidéo éventuels, 40, délivrent alors le signal vidéo utile.

L'invention n'est pas limitée au mode de réalisation précisément décrit et représenté. En particulier, il existe des procédés de transcodage dans lesquels les mots de 8 bits classiquement issus du convertisseur analogique-numérique, à l'émission sont transformés en mots de 10 bits transmis sous forme série. Dans ce cas, un circuit de transformation série-parallèle analogue pourrait être réalisé. Cependant une réalisation sous forme de circuit intégré en réseau prédiffusé est difficile du fait que le débit série 10 x 27 = 270 M bits/s est supérieur à la vitesse maximale indiquée ci-dessus.

Ce circuit est particulièrement applicable à la transmission série dans le domaine de la télévision numérique professionnelle, dans le domaine des magnétoscopes numériques pour la desérialisation des données enregistrées, ou même dans le domaine de télécommunications pour la transmission de données série à desérialiser à la réception.

9  0130899

## REVENDICATIONS

1. Circuit de transformation série-parallèle d'un signal numérique série en une suite de mots binaires parallèles comportant un registre à décalage d'entrée (1) commandé par une horloge série ($H_S$), et relié à un registre à mémoire (2) commandé par une horloge parallèle ($H_p$), ce signal série comportant des séquences de mots de synchronisation fixant sa trame, caractérisé en ce qu'il comporte, en combinaison, un circuit détecteur de coïncidences (6) ayant une première entrée qui reçoit un mot de synchronisation de référence, une seconde entrée recevant le signal numérique série et une sortie délivrant des impulsions de coïncidence lorsque le mot de référence est détecté dans le signal numérique série, un comparateur de phase (7) recevant d'une part les impulsions de coïncidence et d'autre part un signal de référence de phase, au rythme des mots parallèles, issu d'un diviseur (8) dont le rang de division est programmable en fonction du nombre d'éléments binaires de mots parallèles, commandé par l'horloge associée au train numérique série ($H_S$), ce comparateur délivrant des impulsions I ou $\overline{I}$ sur deux sorties suivant que les impulsions de coïncidence sont en phase ou non avec le signal de référence de phase, et un circuit logique (9) à hystérésis relié aux sorties du comparateur transmettant sur ses sorties des impulsions I ou $\overline{I}$ validées lorsqu'un nombre prédéterminé d'impulsions successives de coïncidences ou de non coïncidences sont détectées, les impulsions validées étant appliquées à l'entrée de commande de synchronisation du diviseur programmable (8).

2. Circuit selon la revendication 1, caractérisé en ce que, la séquence de synchronisation étant constituée de suites de mots complémentaires, X et $\overline{X}$, l'un de ces mots est choisi comme mot de référence, le circuit détecteur de coïncidences (6) comportant des moyens d'inversion du mot de référence après chaque détection de coïncidence.

3. Circuit selon l'une des revendications 1 et 2, caractérisé en ce que le circuit logique à hystérésis (9) comporte une entrée de commande fixant le nombre d'impulsions successives nécessaire à la validation des impulsions de coïncidence ou de non coïncidence.

4. Circuit selon la revendication 1, caractérisé en ce qu'il comporte en outre un circuit à mémoire de sortie (3) relié à la sortie du registre à mémoire (2) dans lequel l'écriture des mots parallèles est commandée par l'horloge ($H_p$) et la sortie de ces mêmes mots à destination des circuits d'utilisation est commandée par une horloge parallèle externe de même rythme que l'horloge parallèle ($H_p$) mais éventuellement déphasée ou présentant une gigue de phase par rapport à ($H_p$).

5. Circuit selon les revendications précédentes prises dans leur ensemble, caractérisé en ce que pour renseigner l'opérateur, le circuit comporte en outre une bascule (11) dont les deux entrées sont reliées aux sorties du circuit logique à hystérésis (9) et dont la sortie indique suivant son état que l'horloge parallèle ($H_p$) est synchrone ou non de la trame numérique du signal série, et en ce que le circuit logique à hystérésis a une sortie délivrant un signal d'état qui suit l'évolution du compteur.

6. Circuit selon la revendication 5, pour la transmission d'un signal numérique série à un rythme inférieur à 250 M bits/s, caractérisé en ce qu'il est implanté dans un réseau intégré prédiffusé.

7. Application du circuit selon l'une quelconque des revendications précédentes dans un récepteur de signaux vidéo numériques reçus sous forme série et appliqués sous forme de mots binaires parallèles à un convertisseur numérique-analogique.

0130899

1/1

Fig.1

Fig.2